(19) Europäisches Patentamt / European Patent Office / Office européen des brevets

(11) **EP 1 947 469 B1**

(12) **FASCICULE DE BREVET EUROPEEN**

(45) Date de publication et mention
de la délivrance du brevet:
**23.04.2014 Bulletin 2014/17**

(51) Int Cl.:
***G01R 33/02*** *(2006.01)*

(21) Numéro de dépôt: **08100568.8**

(22) Date de dépôt: **16.01.2008**

(54) **Dispositif d'amplification magnétique comportant un capteur magnétique à sensibilité longitudinale**

Vorrichtung zur magnetischen Verstärkung, die mit einem Magnetempfänger mit Längswellensensiblität ausgestattet ist

Magnetic amplifier device comprising a magnetic sensor with longitudinal sensitivity

(84) Etats contractants désignés:
**DE IT**

(30) Priorité: **19.01.2007 FR 0700376**

(43) Date de publication de la demande:
**23.07.2008 Bulletin 2008/30**

(73) Titulaires:
• **THALES**
  **92200 Neuilly sur Seine (FR)**
• **CENTRE NATIONAL DE
  LA RECHERCHE SCIENTIFIQUE (CNRS)
  75016 Paris (FR)**

(72) Inventeurs:
• **Coillot, Christophe**
  **75015 Paris (FR)**
• **Leroy, Paul**
  **92340 Bourg La Reine (FR)**
• **Chanteur, Gérard**
  **92340 Bourg La Reine (FR)**
• **Roux, Alain**
  **91120 Palaiseau (FR)**
• **Nguyen van Dau, Frédéric**
  **91120 Palaiseau (FR)**

(74) Mandataire: **Esselin, Sophie et al
Marks & Clerk France
Conseils en Propriété Industrielle
Immeuble Visium
22, Avenue Aristide Briand
94117 Arcueil Cedex (FR)**

(56) Documents cités:
EP-A2- 0 772 046     CH-A5- 683 469
JP-A- 2 087 086     US-A- 4 185 265
US-A- 5 483 161

EP 1 947 469 B1

**Description**

Le domaine de l'invention est celui des capteurs magnétiques et notamment des capteurs magnétorésistifs utilisés pour la mesure de champs faibles, c'est à dire inférieurs ou égaux au champ magnétique terrestre. De manière générale, un capteur magnétorésistif utilise la magnétorésistance des matériaux ferromagnétiques, c'est à dire la variation de la résistance électrique d'un conducteur sous l'effet du champ magnétique qui lui est appliqué. En pratique ce type de capteur nécessite l'application d'un courant d'excitation. La tension de sortie obtenue est fonction du courant d'excitation et de la magnétorésistance et permet la lecture de la valeur du champ magnétique appliqué. Selon les capteurs, cette mesure est normale c'est à dire dans une direction orthogonale à la direction du courant ou transverse c'est à dire dans le plan du capteur (colinéaire ou perpendiculaire à la direction du courant).

Les critères employés pour comparer les performances de différents type de capteurs peuvent typiquement être : le plus petit champ magnétique mesurable à une fréquence donnée (typiquement 1Hz), la masse, la bande passante, les dimensions des capteurs et leur consommation lorsqu'ils sont associés à une électronique de conditionnement du signal. En fonction des applications, l'ordre de préférence pour ces critères diffère. Pour les applications du CETP (Centre d'étude des Environnements Terrestres et Planétaires), qui concernent la composante magnétique des ondes dans les plasmas spatiaux, il est envisagé de réaliser des capteurs sensibles à des champs magnétiques et présentant une sensibilité de l'ordre de 100pT/sqrt(Hz) à 1 Hz, ayant une faible masse et une faible consommation pour être embarqués.

Parmi les technologies utilisées pour la réalisation de ce type de magnétomètres, on répertorie notamment :

- Les capteurs à effet Hall : de faible taille, faible consommation, mais dont la sensibilité peut difficilement atteindre 100nT/sqrt(Hz), comme décrit par exemple dans le document JP-A-2087086.

- Les capteurs de type AMR (Magnétorésistance anisotrope) et ses "dérivés", GMR (Magnétorésistance géante) et TMR (Magnétorésistance tunnel) : de faible taille, faible consommation ; leur sensibilité peut affleurer 1 nT/sqrt(Hz) à 1 Hz, les TMR représentant une technologie prometteuse laissant envisager une sensibilité de 10pT/sqrt(Hz) à 1 Hz.

- Les capteurs de type GMI (Magnéto Impédance) : ils présentent une faible consommation, les autres caractéristiques sont encore mal connues puisque ces composants font l'objet d'un regain d'intérêt récent bien que le principe en soit bien connu. Des possibilités de miniaturisation et d'évolution laissent entrevoir une potentielle faible masse et des sensibilités en deçà de 1 nT/sqrt(Hz).

- Les capteurs dits de type « Flux gate » (ou capteurs à vannes de flux) : de loin les plus courants, leur taille conditionne leur sensibilité. Pour des capteurs de quelques dizaines de grammes, on atteint 100pT/sqrt(Hz). La technologie est arrivée à un degré de maturité qui ne laisse pas espérer d'évolutions des performances.

- Les capteurs de type « Squid » : capteur utilisant l'effet Josephson, ce type de capteur nécessite un anneau supraconducteur refroidi à l'hélium liquide, offrant une sensibilité pouvant être inférieure à 1pT/sqrt(Hz)), il est principalement utilisé en médecine. Sa masse et sa consommation sont rédhibitoires dans beaucoup d'applications.

- Les capteurs de type « Search coil » (ou fluxmètre) : très sensible (près de 10fT/sqrt(Hz) à 1kHz) de faible consommation mais encombrant (cube de 10cm de côté). Ces capteurs reposent sur le phénomène d'induction et par principe leur sensibilité excellente pour des fréquences au-delà de quelques Hz, se détériore rapidement lorsque celle-ci diminue et ne permet pas la mesure des champs magnétiques lentement variables (inférieurs à 1 Hz).

A ce jour, les besoins en capteurs magnétiques de précision typique 10 pT sont résolus avec des technologies de type « flux-gate » Néanmoins, ces technologies sont encombrantes, non intégrables et relativement coûteuses en énergie. C'est pourquoi, il est recherché des alternatives à ce type de capteurs magnétiques.

La sensibilité de certains types de capteurs (Hall, notamment) a pu été améliorée en disposant de noyaux magnétiques au centre desquels le capteur est positionné. L'amplification magnétique ainsi obtenue dépend de la distance entre les 2 noyaux, plus cette distance est faible plus cette amplification est élevée. Il a ainsi été montré que l'amplification pouvait localement excéder la perméabilité relative du matériau magnétique et atteindre des amplifications de plus de 1000, lorsque la distance entre les 2 noyaux est de l'ordre de 100µm. (P. Leroy, C. Coillot, A. Roux, G. chanteur, "Optimization of the shape of magnetic field concentrators to improve sensitivity of Hall sensors", actes du congrès SSD'05, 2005). Dans le cas des capteurs à effet Hall cela permet d'envisager des sensibilités de l'ordre de 100pT/sqrt(Hz) à 1 Hz. Toutefois, ce type d'amplification est possible pour des capteurs dont l'épaisseur de la zone dite "sensible" peut être réduite dans des proportions importantes (quelques 10µm), ce qui est plus difficilement le cas de capteurs type : AMR, GMR, TMR et GMI dont la sensibilité au champ magnétique est dans le sens transverse. En effet, une puce de type AMR s'apparente à un parallélépipède (de dimensions de l'ordre de : 2mm*2mm*0.1 mm). Dans ce cas, la distance entre les noyaux est au minimum égale à la largeur de la puce (dans l'exemple précité 2mm) et l'amplification magnétique est alors faible puisque la distance entre les noyaux est importante.

Pour résoudre ce problème et disposer d'un dispositif capable de fortement amplifier la sensibilité d'un capteur magnétorésistif à sensibilité longitudinale de type AMR, GMR, ..., la présente invention propose d'utiliser deux demi noyaux magnétiques dont la forme particulière permet de concentrer le flux magnétique dans la zone sensible de la puce constitutive du capteur, en produisant une amplification du champ magnétique. La puce est placée dans une cavité de telle sorte que sa partie active est dans la zone de confinement du champ magnétique en tirant parti de l'épanouissement des lignes de champ (c'est-à-dire les lignes de champ qui sortent de la zone d'entrefer et qui peuvent également être assimilées à des fuites de flux) entre les deux extrémités des noyaux.

Plus précisément l'invention a pour objet un dispositif d'amplification.

magnétique comportant un capteur magnétique à sensibilité longitudinale caractérisé en ce qu'il comporte une première pièce en matériau magnétique et une seconde pièce en matériau magnétique, chacune des pièces comportant une fente longitudinale au niveau d'une zone centrale, lesdites pièces étant séparées d'une distance dite d'entrefer, le capteur magnétique étant inséré au niveau des deux fentes.

Selon une variante, chaque pièce en matériau magnétique comporte un élément supérieur en matériau magnétique et un élément inférieur en matériau magnétique, lesdits éléments supérieur et inférieur étant dissociés.

Selon une variante, les matériaux magnétiques des éléments supérieur et inférieur sont identiques.

Avantageusement, les première et seconde pièces sont constituées de matériaux magnétiques identiques.

Selon une variante, les éléments supérieur et inférieur sont solidaires et l'élément résultant présente une fente en son centre dans laquelle est positionné le capteur magnétique.

Selon une variante, la distance d'entrefer selon un axe dit longitudinal séparant les extrémités longitudinales des première et seconde pièces est sensiblement égale à la distance selon un axe perpendiculaire à l'axe longitudinal séparant les éléments supérieur et inférieur.

Selon une variante, les première et seconde pièces en matériau magnétique ayant une hauteur de matériau magnétique selon l'axe perpendiculaire à l'axe longitudinal, cette hauteur présente un gradient selon l'axe longitudinal de manière à ce que la plus petite hauteur soit au niveau de l'entrefer.

Selon une variante, les première et seconde pièces en matériau magnétique présentent une forme de clou avec une zone dite extérieure évasée et une zone dite intérieure pointue, ladite zone pointue possédant une fente, le capteur étant inséré dans les fentes desdites première et seconde pièces.

Selon une variante, le capteur magnétique présente selon une direction orthogonale à la direction longitudinale, une partie dite interne insérée dans les deux fentes et une partie dite externe et comportant des contacts conducteurs, la partie interne du capteur présentant une épaisseur plus faible que l'épaisseur de la partie externeSelon une variante, les première et seconde pièces en matériau magnétique sont en ferrite.

L'invention a aussi pour objet un capteur de courant comportant un dispositif d'amplification magnétique selon l'invention dans lesquels les première et seconde pièces sont constituées par un seul élément magnétique torique. Typiquement, on fait passer le courant à mesurer dans un circuit magnétique fermé (par exemple de forme torique). Le courant produit alors un champ magnétique

$$B = \mu o * \mu r * I / (2 * pi * R)$$

et dans le cas d'un circuit magnétique avec entrefer (ce qui est le cas, dés lors qu'on place un capteur magnétique pour la mesure) on a :

$$B = \mu o * \mu r * I / (2 * pi * R + \mu r * d),$$

avec :

    I : le courant à mesurer (et qui est la source du champ B)
    $\mu o$ : perméabilité du vide
    $\mu r$ : perméabilité relative du matériau
    R : est son rayon
    d : distance d'entrefer

En général, on a intérêt à avoir "d" le plus petit possible pour être capable de mesurer le courant le plus précisément possible (puisque B sera plus élevé pour un même courant).

Le champ magnétique est ensuite mesuré par le capteur magnétique à sensibilité longitudinal qui est placé à l'intérieur de la fente.

L'invention sera mieux comprise et d'autres avantages apparaîtront à la lecture de la description qui va suivre donnée à titre non limitatif et grâce aux figures annexées parmi lesquelles :

- la figure 1 illustre un capteur magnétique utilisé dans un dispositif d'amplification magnétique selon l'invention ;
- la figure 2 schématise un dispositif d'amplification magnétique selon l'invention ;
- la figure 3 illustre un premier exemple de dispositif d'amplification magnétique selon l'invention ;

- les figures 4a et 4b illustrent un second exemple de dispositif d'amplification magnétique de forme optimisée selon l'invention ;
- les figures 5a, 5b et 5c illustrent un exemple de montage de structure permettant la fixation des pièces en matériau magnétique et du capteur magnétique.

De manière générale, l'invention concerne un dispositif d'amplification magnétique permettant de détecter de faibles champs magnétiques et comportant un capteur magnétique à sensibilité transverse par exemple de type AMR. Il peut comporter dans ce cas dans un empilement de couches semiconductrices, au moins une couche semiconductrice dopée capable de conduire des électrons, des moyens pour appliquer un courant électrique et des moyens pour mesurer une tension, la tension mesurée V répondant à l'équation suivante :

$$V = K\ I\ B$$

Avec

K une constante
I le courant appliqué
B le champ magnétique en présence

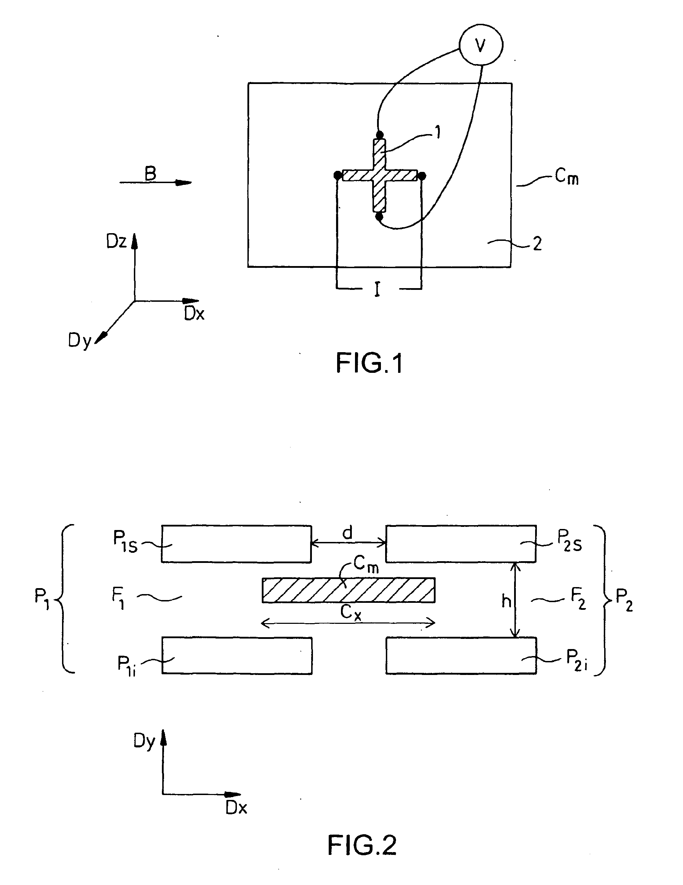

La figure 1 illustre une vue de dessus d'un exemple de capteur de champ magnétique Cm comportant une croix semiconductrice dopée 1, le courant appliqué et la tension mesurée étant selon deux directions orthogonales Dx et Dz, pour mesurer la composante du champ magnétique selon la direction Dx dite longitudinale. Typiquement la couche semiconductrice dopée de quelques micromètres d'épaisseur peut être réalisée sur un substrat semiconducteur 2 de quelques centaines de micromètres.

Selon l'invention, ce type de capteur Cm est positionné entre deux pièces $P_1$ et $P_2$ en matériau magnétique comme illustré schématiquement en figure 2. Chaque pièce présente un élément dit supérieur et un élément dit inférieur, lesdites pièces présentant une fente. Ainsi le capteur 1 est positionné entre une première pièce $P_1$ comportant elle-même deux éléments $P_{1s}$ et $P_{1i}$ et une fente $F_1$ et une seconde pièce $P_2$ comportant elle-même deux éléments $P_{2s}$ et $P_{2i}$ et une fente $F_2$. Les pièces en matériau magnétique sont séparées d'une distance dite d'entrefer d selon une direction Dx et les fentes présentent une hauteur h selon la direction Dy. Avantageusement la dimension longitudinale Cx du capteur présente un recouvrement non nul avec les pièces en matériau magnétique comme illustré en figure 2, de manière à assurer un meilleur recouvrement entre les lignes de champ magnétiques et le capteur magnétique.

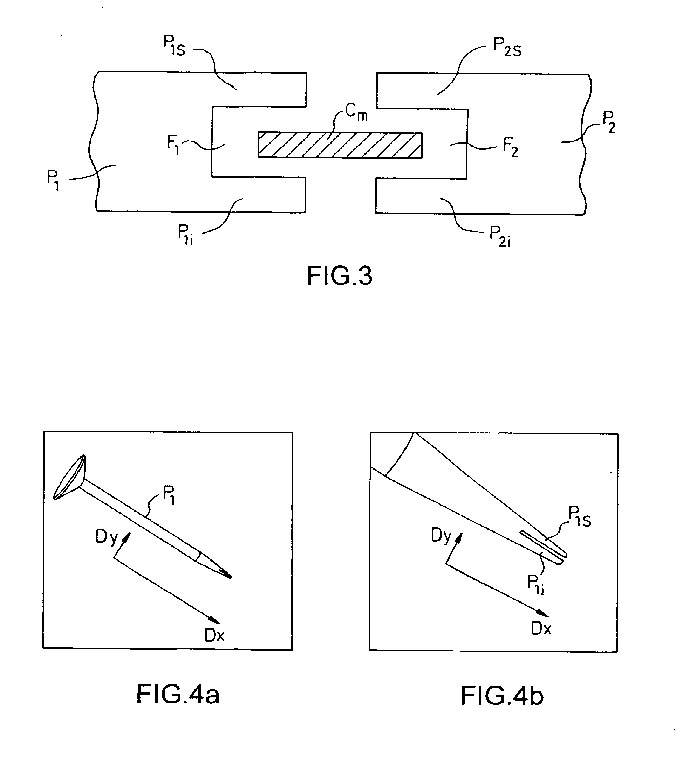

La figure 3 illustre un premier exemple de dispositif d'amplification magnétique selon l'invention dans lequel, les éléments supérieur et inférieur sont solidaires et comportent en leur centre une fente. Ils permettent d'obtenir des champs magnétiques de direction parallèle à la direction Dx.

De plus, l'amplification magnétique obtenue est aussi élevée dans la zone appelée fente que dans la zone d'entrefer, dès lors que l'épaisseur de la fente est égale à la distance d'entrefer.

Selon une variante de l'invention illustrée en figures 4a et 4b relative à un agrandissement d'une pièce en matériau magnétique utilisée dans un dispositif de l'invention, la pièce en matériau magnétique présente avantageusement une forme de clou avec une extrémité évasée permettant de concentrer le champ magnétique sur la longueur de ladite pièce encore appelée noyau, de même la terminaison en pointe permet de confiner le champ magnétique dans la zone ou est placé le capteur de champ magnétique. Le capteur magnétique peut ainsi avantageusement être inséré au niveau des deux fentes, il est avantageusement aminci à ce niveau pour être plus large à l'extérieur desdites fentes selon une direction Dz perpendiculaire aux directions Dx et Dy.

Typiquement les dimensions du capteur magnétique peuvent être de l'ordre de quelques millimètres selon les directions Dx et Dy et selon la direction Dz de quelques dizaines de microns d'épaisseur dans la région active amincie pouvant atteindre quelques centaines de microns dans la région dite externe au niveau de laquelle sont réalisées les prises de contact sur le capteur magnétique.

Concernant les dimensions des pièces ou noyaux magnétiques, les dimensions selon la direction Dy peuvent typiquement être comprises entre quelques millimètres et quelques centaines de millimètres. Le diamètre dans la partie évasée pouvant être de l'ordre de quelques millimètres alors que le diamètre au centre dans la région active peut typiquement être compris entre un dixième de millimètres et quelques millimètres. L'épaisseur des fentes réalisées dans les noyaux magnétiques peut avantageusement être comprise entre environ quelques dizaines de micromètres et quelques centaines de micromètres. L'entrefer est dans ce cas avantageusement compris entre également quelques dizaines de micromètres et quelques centaines de micromètres.

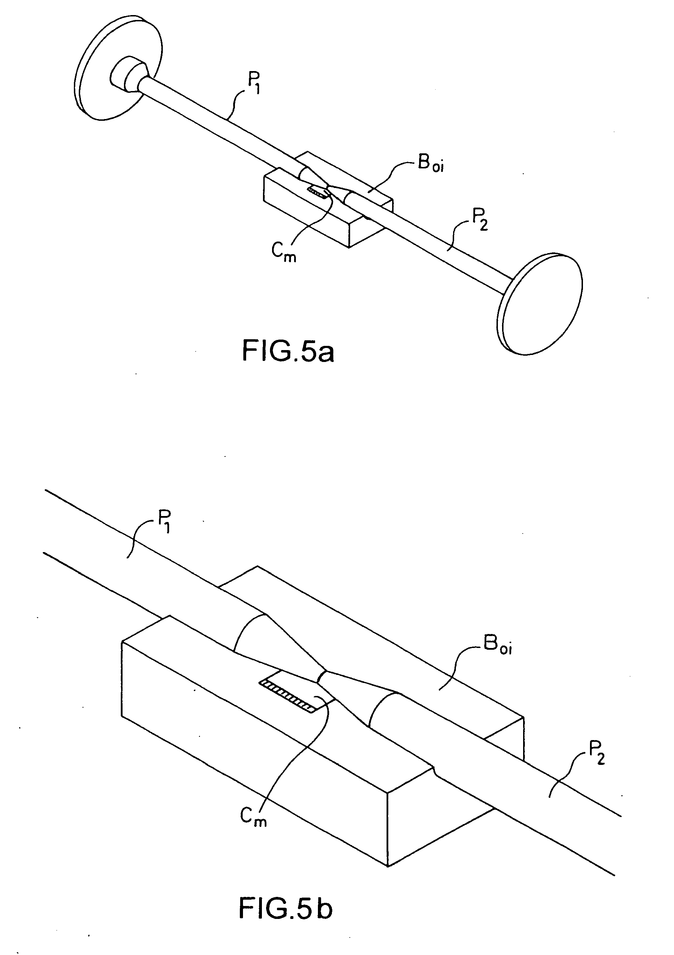

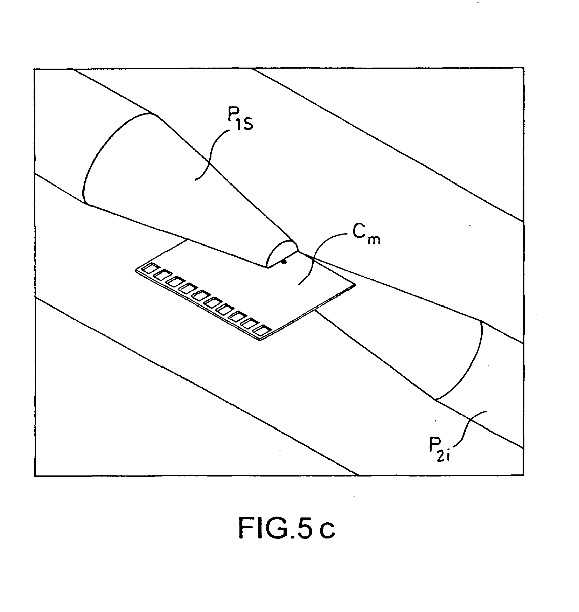

Nous allons décrire ci-après un exemple de structure permettant de solidariser les deux pièces magnétiques $P_1$ et $P_2$ ainsi que le capteur Cm. Cet exemple de structure est illustré en figures 5a et 5b, 5c qui représentent des vues agrandies des extrémités dites internes des pièces $P_1$ et $P_2$. Les pièces $P_1$ et $P_2$ sont typiquement les pièces telles que celles représentées en figure 4a et 4b, leurs extrémités en forme de pointe sont fixées à un boîtier Boi Le capteur magnétique est intégré au niveau des fentes des deux pièces et est également solidaire dudit boîtier. La figure 5c illustre plus en détails l'élément supérieur $P_{1S}$ de la pièce $P_1$ et l'élément inférieur $P_{2i}$ de la pièce $P_2$, mettant en évidence le capteur Cm intégré au niveau des fentes des pièces $P_1$ et $P_2$.

**Revendications**

1. Dispositif d'amplification magnétique comportant un capteur magnétique (Cm) de type : AMR, GMR, TMR, GMI dont la sensibilité au champ magnétique est dans le sens transverse **caractérisé en ce :**

   - **que** les dimensions du capteur magnétique sont de l'ordre de quelques millimètres selon les directions Dx et Dy et quelques centaines de microns d'épaisseur et
   - **qu'**il comporte une première pièce (P₁) en matériau magnétique et une seconde pièce (P₂) en matériau magnétique, chacune des pièces comportant une fente longitudinale (F₁,F₂), lesdites pièces étant séparées d'une distance dite d'entrefer, le capteur magnétique étant inséré au niveau des deux fentes.

2. Dispositif d'amplification magnétique selon la revendication 1, **caractérisé en ce que** chaque pièce en matériau magnétique comporte un élément supérieur (P₁ₛ, P₂ₛ) en matériau magnétique et un élément inférieur (P₁ᵢ, P₂ᵢ) en matériau magnétique, lesdits éléments supérieur et inférieur étant dissociés.

3. Dispositif d'amplification magnétique selon la revendication 2, **caractérisé en ce que** les matériaux magnétiques des éléments supérieurs et inférieurs sont identiques.

4. Dispositif d'amplification magnétique selon l'une des revendications 1 à 3, **caractérisé en ce que** les premières et secondes pièces sont constituées de matériaux magnétiques identiques.

5. Dispositif d'amplification magnétique selon l'une des revendications 2 à 4, **caractérisé en ce que** les éléments supérieur et inférieur sont solidaires et présentent une fente en son centre dans laquelle est positionné le capteur magnétique.

6. Dispositif d'amplification magnétique selon l'une des revendications 1 à 5, **caractérisé en ce que** la distance d'entrefer (d) selon un axe dit longitudinal séparant les extrémités longitudinales des première et seconde pièces est sensiblement égale à la distance (h) selon un axe perpendiculaire à l'axe longitudinal séparant les éléments supérieur et inférieur.

7. Dispositif d'amplification magnétique selon l'une des revendications 1 à 6, **caractérisé en ce que** les première et seconde pièces en matériau magnétique ayant une hauteur de matériau magnétique selon l'axe perpendiculaire à l'axe longitudinal, cette hauteur présente un gradient selon l'axe longitudinal de manière à ce que la plus petite hauteur soit au niveau de l'entrefer.

8. Dispositif d'amplification magnétique selon l'une des revendications 1 à 7, **caractérisé en ce que** les première et seconde pièces en matériau magnétique présentent une forme de clou avec une zone dite extérieure évasée et une zone dite intérieure pointue, ladite zone pointue possédant une fente, le capteur étant inséré dans les fentes desdites première et seconde pièces.

9. Dispositif d'amplification magnétique selon l'une des revendications 1 à 8, **caractérisé en ce que** le capteur magnétique présente selon une direction orthogonale à la direction longitudinale, une partie dite interne insérée dans les deux fentes et une partie dite externe et comportant des contacts conducteurs, la partie interne du capteur présentant une épaisseur plus faible que l'épaisseur de la partie externe.

10. Dispositif d'amplification magnétique selon l'une des revendications 1 à 9, les première et seconde pièces en matériau magnétique sont en ferrite.

11. Capteur de courant comportant un dispositif d'amplification magnétique selon l'une des revendications 1 à 10, dans lequel les première et seconde pièces sont constituées par un seul élément magnétique fermé.

12. Capteur de courant selon la revendication 11, **caractérisé en ce que** le seul élément magnétique fermé est de forme torique.

**Patentansprüche**

1. Magnetische Verstärkungsvorrichtung, die einen Magnetsensor (Cm) des Typs AMR, GMR, TMR oder GMI umfasst, dessen Empfindlichkeit für das Magnetfeld in der Querrichtung ist, **dadurch gekennzeichnet, dass**:

   - die Abmessungen des Magnetsensors in der Größenordnung von ein paar Millimetern in den Richtungen Dx und Dy und von ein paar hundert Mikron Dicke sind, und
   - sie einen ersten Teil (P₁) aus einem magnetischen Material und einen zweiten Teil (P₂) aus einem magnetischen Material umfasst, wobei jeder der Teile einen Längsschlitz (F₁, F₂) aufweist, wobei die Teile durch eine als Spalt bezeichnete Distanz voneinander beabstandet sind, wobei der Magnetsensor an den beiden Schlitzen eingeführt wird.

2. Magnetische Verstärkungsvorrichtung nach Anspruch 1, **dadurch gekennzeichnet, dass** jeder Teil aus magnetischem Material ein oberes Element

($P_{1S}$, $P_{2S}$) aus magnetischem Material und ein unteres Element ($P_{1i}$, $P_{2i}$) aus magnetischem Material umfasst, wobei das obere und das untere Element dissoziiert sind.

3. Magnetische Verstärkungsvorrichtung nach Anspruch 2, **dadurch gekennzeichnet, dass** die magnetischen Materialien des oberen und unteren Elements identisch sind.

4. Magnetische Verstärkungsvorrichtung nach einem der Ansprüche 1 bis 3, **dadurch gekennzeichnet, dass** der erste und zweite Teil aus identischen magnetischen Materialien gebildet sind.

5. Magnetische Verstärkungsvorrichtung nach einem der Ansprüche 2 bis 4, **dadurch gekennzeichnet, dass** das obere und das untere Element starr miteinander verbunden sind und einen Schlitz in der Mitte haben, in dem der Magnetsensor positioniert ist.

6. Magnetische Verstärkungsvorrichtung nach einem der Ansprüche 1 bis 5, **dadurch gekennzeichnet, dass** der Spaltabstand (d) entlang einer als Längsachse bezeichneten Achse, die die Längsenden des ersten und zweiten Teils trennt, im Wesentlichen gleich der Distanz (h) entlang einer Achse lotrecht zu der das obere und das untere Element trennenden Längsachse ist.

7. Magnetische Verstärkungsvorrichtung nach einem der Ansprüche 1 bis 6, **dadurch gekennzeichnet, dass** der erste und zweite Teil aus magnetischem Material eine Höhe von magnetischem Material entlang der Achse lotrecht zur Längsachse haben, wobei die Höhe einen Gradienten entlang der Längsachse hat, so dass die geringste Höhe beim Spalt ist.

8. Magnetische Verstärkungsvorrichtung nach einem der Ansprüche 1 bis 7, **dadurch gekennzeichnet, dass** der erste und zweite Teil aus magnetischem Material nagelförmig mit einer erweiterten äußeren Zone und einer zugespitzten inneren Zone sind, wobei die zugespitzte Zone einen Schlitz hat, wobei der Sensor in die Schlitze des ersten und zweiten Teils eingeführt wird.

9. Magnetische Verstärkungsvorrichtung nach einem der Ansprüche 1 bis 8, **dadurch gekennzeichnet, dass** der Magnetsensor in einer Richtung orthogonal zur Längsrichtung einen in die beiden Schlitze eingeführten, als innerer Teil bezeichneten Teil und einen als äußerer Teil bezeichneten Teil hat, der leitende Kontakte umfasst, wobei die Dicke des inneren Teils des Sensors geringer ist als die Dicke des äußeren Teils.

10. Magnetische Verstärkungsvorrichtung nach einem der Ansprüche 1 bis 9, wobei der erste und zweite Teil aus magnetischem Material aus Ferrit gefertigt sind.

11. Stromsensor, der eine magnetische Verstärkungsvorrichtung nach einem der Ansprüche 1 bis 10 umfasst, wobei der erste und zweite Teil von einem einzigen geschlossenen magnetischen Element gebildet werden.

12. Stromsensor nach Anspruch 11, **dadurch gekennzeichnet, dass** das einzige geschlossene magnetische Element ringförmig ist.

**Claims**

1. A magnetic amplification device comprising a magnetic sensor (Cm) of the AMR, GMR, TMR or GMI type, for which the sensitivity to the magnetic field is in the transverse direction, **characterised in that**:

    - the dimensions of the magnetic sensor are of the order of a few millimetres along the directions Dx and Dy and of a few hundred microns thick, and
    - that it comprises a first part ($P_1$) made from magnetic material and a second part ($P_2$) made from magnetic material, each of said parts comprising a longitudinal slot ($F_1$, $F_2$), said parts being separated by a distance referred to as a gap, said magnetic sensor being inserted at the two slots.

2. The magnetic amplification device according to claim 1, **characterised in that** each part made from magnetic material comprises an upper element ($P_{1S}$, $P_{2S}$) made from magnetic material and a lower element ($P_{1i}$, $P_{2i}$) made from magnetic material, said upper and lower elements being dissociated.

3. The magnetic amplification device according to claim 2, **characterised in that** the magnetic materials of said upper and lower elements are identical.

4. The magnetic amplification device according to any one of claims 1 to 3, **characterised in that** said first and second parts are constituted by identical magnetic materials.

5. The magnetic amplification device according to any one of claims 2 to 4, **characterised in that** said upper and lower elements are rigidly connected together and have a slot at the centre, with said magnetic sensor being located in said slot.

6. The magnetic amplification device according to any one of claims 1 to 5, **characterised in that** the gap distance (d) along an axis, referred to as longitudinal axis, which separates the longitudinal ends of said first and second parts, is substantially equal to the distance (h) along an axis perpendicular to the longitudinal axis separating said upper and lower elements.

7. The magnetic amplification device according to any one of claims 1 to 6, **characterised in that** said first and second parts made from magnetic material have a height of magnetic material along the axis perpendicular to the longitudinal axis, said height having a gradient along the longitudinal axis so that the lowest height is at the level of the gap.

8. The magnetic amplification device according to any one of claims 1 to 7, **characterised in that** said first and second parts made from magnetic material are nail shaped with a flared outer zone and pointed inner zone, said pointed zone having a slot, with said sensor being inserted into the slots of said first and second parts.

9. The magnetic amplification device according to any one of claims 1 to 8, **characterised in that** said magnetic sensor has a part, referred to as internal part, along a direction orthogonal to the longitudinal direction inserted into the two slots and a part, referred to as external part, comprising conducting contacts, with the thickness of said internal part of said sensor being thinner than the thickness of said external part.

10. The magnetic amplification device according to any one of claims 1 to 9, said first and second parts made from magnetic material being made from ferrite.

11. A current sensor comprising a magnetic amplification device according to any one of claims 1 to 10, wherein said first and second parts are constituted by a single closed magnetic element.

12. The current sensor according to claim 11, **characterised in that** said single closed magnetic element is ring shaped.

FIG.1

FIG.2

FIG.3

FIG.4a

FIG.4b

FIG.5a

FIG.5b

FIG.5 c

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• JP 2087086 A

**Littérature non-brevet citée dans la description**

• **P. LEROY ; C. COILLOT ; A. ROUX ; G. CHANTEUR.** Optimization of the shape of magnetic field concentrators to improve sensitivity of Hall sensors. *actes du congrès SSD'05,* 2005